(19) Europäisches Patentamt

European Patent Office

Office européen des brevets

(11) **EP 1 075 029 A1**

(12) **EUROPEAN PATENT APPLICATION**
published in accordance with Art. 158(3) EPC

(43) Date of publication:
07.02.2001 Bulletin 2001/06

(51) Int. Cl.[7]: **H01L 29/74**

(21) Application number: **99913664.1**

(86) International application number:
**PCT/JP99/01989**

(22) Date of filing: **14.04.1999**

(87) International publication number:
**WO 99/54940 (28.10.1999 Gazette 1999/43)**

(84) Designated Contracting States:
**DE FR GB**

(30) Priority: **15.04.1998 JP 10434898**

(71) Applicant: **Hitachi, Ltd.**
**Chiyoda-ku, Tokyo 101-8010 (JP)**

(72) Inventors:
• **SAKANO, Junichi,**
**Hitachi Res. Lab. Hitachi Ltd**
**Ibaraki 319-1221 (JP)**

• **KOBAYASHI, Hideo,**
**Hitachi Res. Lab. Hitachi Ltd**
**Ibaraki 319-1221 (JP)**
• **MORI, Mutsuhiro,**
**Hitachi Res. Lab. Hitachi Ltd**
**Ibaraki 319-1221 (JP)**

(74) Representative:
**Strehl Schübel-Hopf & Partner**
**Maximilianstrasse 54**
**80538 München (DE)**

(54) **COMPOSITE SEMICONDUCTOR DEVICE**

(57) An MIS gate type semiconductor device having a low resistive loss in the ON state and a wide safe operation region is disclosed. In this semiconductor device, the p-base layer of the thyristor and the emitter electrode are connected together using a suitable non-linear device. As a result, lower loss and higher capacity of the semiconductor device can be realized in order not only to make it easy to turn ON the thyristor but also to make the safe operation region wide.

FIG.1B

FIG.1A

EP 1 075 029 A1

**Description**

BACKGROUND OF THE INVENTION

The present invention is related to a complex semiconductor device that can be turned ON and OFF by an MIS (Metal Insulator Semiconductor) gate, has a resistive loss in the ON state, and is suitable for large current operation, and in particular, to a complex semiconductor device having a low loss as well a wide safe operating region, and to an electric power conversion apparatus using it.

Because of the requirements of higher performance of electric power conversion apparatuses such as inverters, it has become desirable to develop semiconductor switching devices with high speeds, low losses, and large current capacities. In the recent years, the device in which a thyristor is controlled by an MIS gate (MIS controlled thyristor) has drawn a lot of attention as a semiconductor switching device capable of meeting these requirements. Since such an MIS controlled thyristor can realize lower ON voltages compared to an IGBT (Insulated Gate Bipolar Transistor) in which an MIS gate controls a bipolar transistor, the resistive loss in the ON state is low and is suitable for higher breakdown voltage applications. The MIS controlled thyristor, in which an MISFET is connected in series with a thyristor and switching is done by making the current path of the thyristor conductive or non-conductive using this MISFET, is suitable for application to large currents because there is less likelihood of the current being concentrated in a single device due to the current limiting action of the series connected MISFET, even when the devices are integrated and are made to operate in parallel. In addition, it is easier for the thyristor to became ON and reduction in the resistive loss can be expected, particularly in a device having a structure such that the p-base layer of the thyristor goes to the floating voltage condition in the ON state.

Devices of this type have been discussed, for example, in ISPSD 1993 (Proceedings of the 1993 International Symposium on Power Semiconductor Devices and ICs, Tokyo, pp. 71~76).

The feature of this semiconductor device is that, since electrons are injected from the n2+ layer due to the operation of the thyristor, there will be a stronger modulation of the conductivity compared to an independent IGBT, and it is possible to realize a low ON voltage. Further, similar to an IGBT, since the ON and OFF states can be realized by the application and removal of voltage to the insulated gate, it is possible to maintain the feature of the gate circuit becoming extremely simplified, similar to a conventional IGBT.

In the above conventional semiconductor device, there was the problem that the safe operation region was narrower compared to an IGBT, and also, it was hard for the device itself to become ON, and the ON voltage increased thereby increasing the loss.

On the other hand, as a method of suppressing the potential rise of the p-base layer, a device in which a Zener diode is inserted between the p-base layer and the collector electrode of the thyristor has been reported in Japanese Unexamined Patent Publication No. Hei 8-330570.

However, there was still the problem that the safe operation region did not get improved even when a Zener diode is connected in this manner.

SUMMARY OF THE INVENTION

The purpose of the present invention is to provide an MIS controlled type complex semiconductor device with the feature that the safe operating region is wide while maintaining the features of ease of being switched ON and low resistive loss, and to provide an electric power conversion apparatus using such a device.

In the present invention, the p-base layer and the emitter layer in the thyristor region in the MIS controlled thyristor are connected together using suitable nonlinear element. In other words, the p-base layer and the emitter layer are connected by a nonlinear element, which has a high resistance when the device is in the ON state, and has a low resistance in the turn-OFF state which determines the safe operating region.

According to the present invention, the ON voltage becomes low since the thyristor operation occurs sufficiently in the ON state, and during turn-OFF, the p-base layer and the emitter layer are connected by a low resistance, and hence the potential of the p-base layer does not rise, thereby making it possible to obtain a wide safe operating region.

Further, the present invention can also be applied when the conductivity types of the different semiconductor layers of the MIS controlled type thyristor are reversed, that is the structure is one in which the p-type and the n-type are interchanged.

BRIEF DESCRIPTION OF DRAWINGS

Fig. 1A and Fig. 1B are drawings showing a preferred embodiment of the present invention.
Fig. 2 is a diagram showing the electrical characteristics of the device of Fig. 1.
Fig. 3A and Fig. 3B are figures showing a conventional example.
Fig. 4A and Fig. 4B are figures showing another conventional example.
Fig. 5A and Fig. 5B are figures showing another preferred embodiment of the present invention.
Fig. 6A and Fig. 6B are figures showing yet another preferred embodiment of the present invention.
Fig. 7A and Fig. 7B are figures showing yet another preferred embodiment of the present invention.

Fig. 8A and Fig. 8B are figures showing an example of configuring an inverter for driving a motor using a semiconductor device according to the present invention.

Fig. 9A and Fig. 9B are figures showing yet another preferred embodiment of the present invention.

Fig. 10 is a diagram showing an inverter apparatus using a semiconductor device according to the present invention.

DETAILED DESCRIPTION OF THE EMBODIMENT

Before describing the details of the present invention, firstly, the problems in the two conventional technologies explained above will be described here concretely while referring to the drawings.

To begin with, we shall explain about a conventional semiconductor device disclosed in the publication in Proceedings of the 1993 International Symposium on Power Semiconductor Devices and ICs, Tokyo, pp. 71-76.

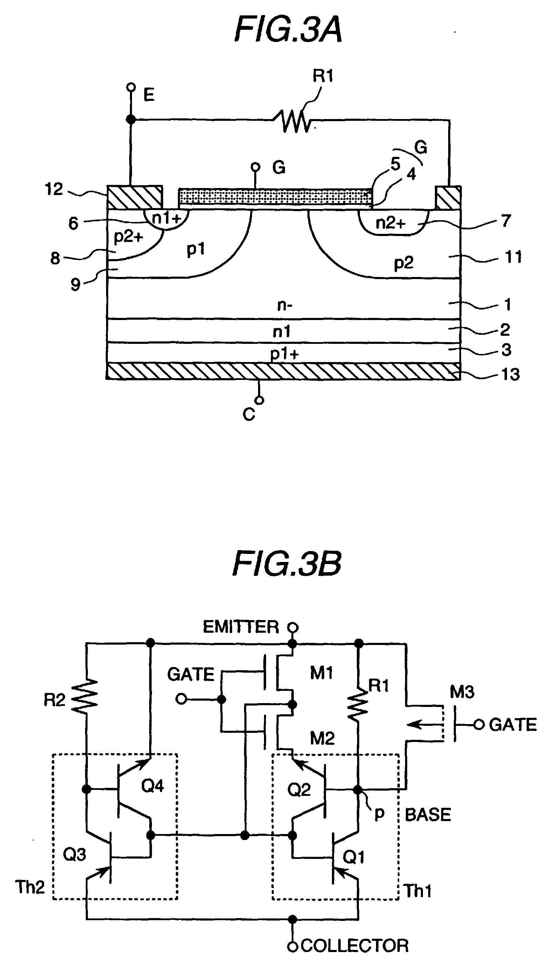

Figures 3A and 3B, respectively show the cross-sectional structural view and the equivalent circuit of the conventional semiconductor device. This semiconductor device is formed by providing an n1 layer 2 and a p1+ layer 3 on the back surface of an n-substrate (n- layer) 1. On the front surface of the substrate is formed an insulated gate G consisting of an insulating film 4 and a gate electrode 5, and an n1+ layer 6 and an n2+ layer 7 are formed on the main front surface so that they extend below the insulated gate G. The p2+ layer 8 with a high impurity concentration and in contact with the n1+ layer 6 is formed from the main front surface, and the p1 layer 9 is provided so that it surrounds the n1+ layer 6. The p2 layer 11 is provided so that it surrounds the n2+ layer 7. The emitter electrode 12 is provided so that it is in contact with the n1+ layer 6 and the p2+ layer 8. On the back surface of the substrate is provided the collector electrode 13 so that it is in contact with the p1+ layer 3. The p2 layer 11 and the emitter electrode 12 are connected via a semiconductor region not shown in the figure and the resistance between them is indicated as R1.

As is evident from the equivalent circuit shown in Fig. 3B, this device contains a thyristor (Th1) configured by the pnp transistor (Q1) formed by the p1+ layer 3, the n- layer 1, and the p2 layer 11, and the npn transistor (Q2) formed by the n- layer 1, p2 layer 11, and the n2+ layer 7. This thyristor Th1 is connected to the emitter electrode 12 via the n-channel MISFET (M2) configured by the n- layer 1, the p2 layer 11, and n2+ layer 7 and the n-channel MISFET (M1) configured by the n1+ layer 6, p1 layer 9, and the n- layer 1.

Further, the transistor Q1 is connected to the emitter electrode 12 via the resistor R1, and the p-channel MISFET (M3) configured by the p1 layer 9, n-layer 1, and the p2 layer 11, which MISFET M3 is in series with the lateral resistance (R3) of the p2 layer 11. In addition, there is an IGBT region consisting of M1 and the pnp transistor (Q3) configured by the p1+ layer 3, n- layer 1, and p1 layer 9. In addition, in this device, there is a parasitic thyristor (Th2) comprising the npn transistor (Q4) configured by the n- layer 1, p1 layer 9, and n1+ layer 6, and the pap transistor (Q3). The p1 layer 9, which is the base layer of Q4, is connected to the emitter electrode 12 via the low resistance R2. Because of this, the current amplification factor of Q4 is low, and normally, Th2 does not go ON. In this manner, this conventional device can be considered to be a device in which an IGBT and thyristors are combined together.

Next, the principle of operation of the conventional semiconductor device shown in Fig. 3A is described below. Firstly, to turn ON this semiconductor device, a positive voltage is applied to the collector electrode 13 and the gate electrode 5 with respect to the emitter electrode 12. Because of this, an n-type inversion layer will be formed on the surfaces of the p1 layer 9 and the p2 layer 11 under the insulated gate G (M1 and M2 become ON). Further, because an n-type accumulation layer is formed on the surface of the n- layer 1 under the insulated gate G, the emitter electrode 12 and the n2 layer 7 are connected via this n-type accumulation layer and M1, and M2. As a result of M1 becoming ON, electrons are injected into the n- layer 1 via M1. Because of this electron injection, the potential of the n-layer 1 gets reduced, and holes are injected from the p1+ layer 3 into the n- layer 1. The injected holes get diffused in the n- layer 1 and are injected into the p2 layer 11, which is the base layer of Q2. Because of this hole injection, the potential of the p2 layer 11 rises, and electrons are injected from the n2+ layer 7 (Q2 becomes ON). As a consequence, the thyristor Th1 becomes ON, and the semiconductor device goes into the ON state.

On the other hand, in order to turn OFF the device, the gate electrode G is made to have the same potential as or is biased negatively with respect to the emitter electrode 12. As a result of this, the n-type inversion layer on the surface of the p1 layer 9 under the insulated gate G disappears, M1 and M2 become OFF shutting off electron injection from the n1+ layer 6 to the n2+ layer 7, thereby turning OFF Q1. During the process in which Q1 becomes OFF, the holes accumulated in the n- layer 1 which is the base of Q1 flow to the emitter electrode 12. As a consequence of Q1 ands Q3 having become OFF, even the injection of holes from the p1+ layer 3 gets shut off, and the semiconductor device goes into the OFF state.

The feature of this conventional semiconductor device is that, since electron injection is made from the n2+ layer 7 because of thyristor action, a stronger conductivity modulation occurs compared to an independent IGBT, and hence it becomes possible to realize a low ON voltage. Also, similar to an IGBT, since the device can be turned ON and OFF by the application and removal of a voltage to the insulated gate, it is possible to maintain the feature of the gate circuit becoming extremely simple as in a conventional IGBT.

The above conventional type of semiconductor device has the problem that the safe operation region is narrow compared to an IGBT. This is because, when the current becomes large, since holes flow into the P2 layer 11 which is the -base of the thyristor Th1 at the time the device is turned OFF, the potential of the p2 layer 11 rises due to the resistances R1 and R3, and large voltages are applied between the p1 layer 9 and the n2+ layer 7 and between the p1 layer 9 and the gate G thereby causing these junctions to breakdown. At this time, if R1 and R3 are made small, the potential rise of the p2 layer 11 is reduced and the safe operating regions becomes wider. However, at the same time, the current amplification factor of Q2 decreases, and it becomes difficult for the thyristor to get turned ON. Therefore, there is the problem that the entire device itself becomes harder to get turned ON, the ON voltage increases, and the loss increases.

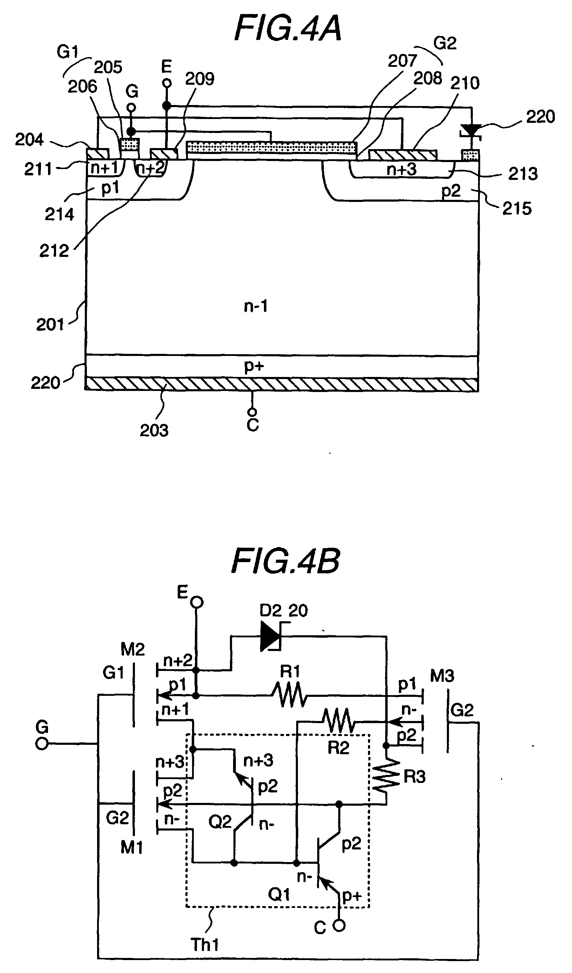

Next, as a method of suppressing the potential rise of the p-base layer, the semiconductor device disclosed in Japanese Unexamined Patent Publication No. Hei 8-330570 is described below in concrete terms by referring to Fig. 4A and Fig. 4B.

The cross-sectional structural diagram of this device is shown in Fig. 4A. In this semiconductor device, a p+ layer 202 is formed on the back surface of the n- substrate (n-1 layer) 201. A collector electrode (C) 203 is provided in contact with this P+ layer 202 via a low resistance.

An insulated gate G201 comprising a gate electrode 205 and an insulating film 206, and an insulated gate G202 comprising a gate electrode 207 and an insulating film 208 are formed on the front surface of the n-substrate. The n+1 layer 211 and the n+2 layer 212 are formed from the main front surface so that they reach below the insulated gate 201 and are present on both sides of the insulated gate G201. Further, the n+3 layer 213 is formed from the main front surface so that it reaches below the insulated gate 202 and is present on the side of the insulated gate G202 opposite to that of the n+2 layer 212. The p1 layer 214 is provided so that it encloses the n+1 layer 211 and the n+2 layer 212. The p2 layer 215 is provided so that it encloses the n+3 layer 213. The electrode 204 is provided so that it is in contact with the n+1 layer 211 via a low resistance.

The emitter electrode (E) 209 is formed so that it is in contact with the n+2 layer 212 and the p1 layer 214 via a low resistance. The electrode 210 is provided so that it is contact with the n+3 layer 213 via a low resistance. The electrodes of the insulated gates G201 and G202 are connected by a low resistance interconnection electrode. In addition, a Zener diode 220 is connected between the p2 layer 215, which is the p-base layer of the thyristor, and the emitter electrode with the cathode of the Zener diode being on the side of the p2 layer 215.

The equivalent circuit of this complex semiconductor device is shown in Fig. 4B. This device contains a thyristor (Th1) configured by the pnp transistor (Q1) formed by the p+ layer 202, the n-1 layer 201, and the p2 layer 215, and the npn transistor (Q2) formed by the n-1 layer 201, p2 layer 215, and the n+3 layer 213. This thyristor Th1 is connected to the emitter electrode (E) 209 via the electrode 210, interconnection electrode, electrode 204, insulated gate G201, and the n-channel MISFET (M2) configured by the n+1 layer 211, the p1 layer 214, and n+2 layer 212. Further, the source and drain of the n-channel MISFET (M1) configured by the n+3 layer 213, p2 layer 215, and the n-1 layer 201 are respectively connected to the emitter and collector of the transistor Q2. The p-channel MISFET (M3) configured by the p1 layer 214, the n-1 layer 201, and the p2 layer 215 is provided between the p1 layer 214 and the p2 layer 215. In addition, a Zener diode 220 is connected between the p2 layer 215 and the emitter electrode. The cathode of this diode 220 is connected to the p2 layer 215, which is the p-base layer of the thyristor. The Zener voltage of this Zener diode 220 in this case is made lower than the breakdown voltage between the source and drain of the MISFET (M2), that is, between the n+1 layer 211 and the n+2 layer 212.

The operation of this device is almost the same as the operation of the device shown in Fig. 3A. In the device of Fig. 4A, the potential of the p2 layer 215 rises at the time of switching, and the voltage applied to M2 connected in series with the thyristor also rises. However, since the potential of the p2 layer 212 does not exceed the Zener voltage due to the operation of the Zener diode 220, the voltage applied to M2 will at the most be equal to the Zener voltage, and hence, a voltage, exceeding the breakdown voltage of M2 will not be applied to M2. Therefore, there will be no breakdown of M2, and hence the safe operating region becomes wider. However, in the conventional device of Fig. 3A, the breakdown voltage of the MISFET (M2) connected in series with the thyristor is high, and since the mechanism determining the safe operating region is different from that of the device of Fig. 4A, there will be no improvement in the safe operating region in the device of Fig. 3A even if a Zener diode having similar characteristics as that of the conventional device of Fig. 4A is connected.

The semiconductor device according to the present invention to be described below is a complex semiconductor device in which the above disadvantages have been improved upon, that is, an MIS controlled type complex semiconductor device in which the features of ease of switching ON and low resistive loss are maintained, and at the same time, a wide safe operation region has been achieved.

The preferred embodiments of the present invention are described below in detail while referring to the figures.

[PREFERRED EMBODIMENT 1]

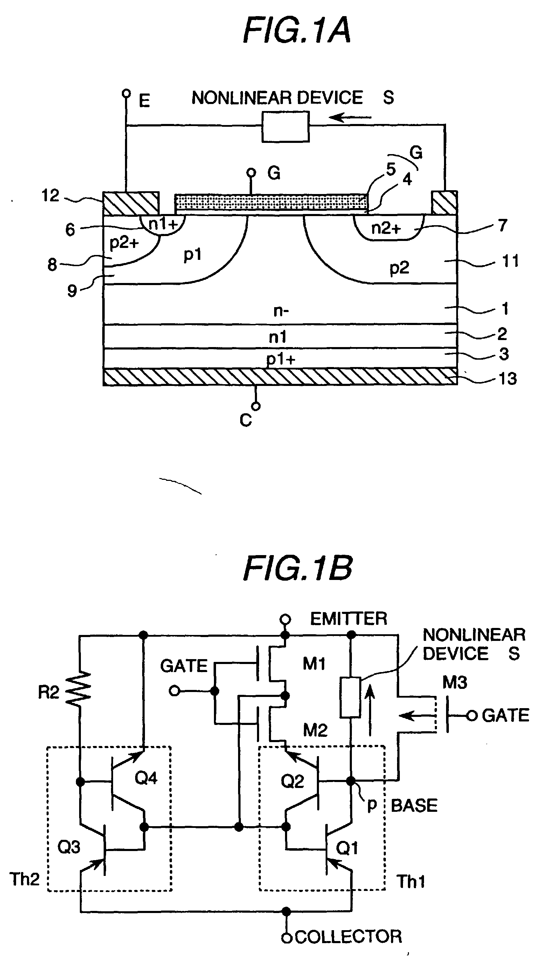

Figures 1A and 1B, respectively show the cross-sectional structural view and the equivalent circuit of the semiconductor device according to one preferred embodiment of the present invention. This semiconductor device is formed by providing an n1 layer 2 and a p1+ layer 3 on the back surface of an n-substrate (n-layer) 1. On the front surface of the substrate is formed an insulated gate G consisting of an insulating film 4 and a gate electrode 5, and an n1+ layer 6 and an n2+ layer 7 are formed on the main front surface so that they extend below the insulated gate G. The p2+ layer 8 with a high impurity concentration and in contact with the n1+ layer 6 is formed from the main front surface, and the p1 layer 9 is provided so that it surrounds the n1+ layer 6. The p2 layer 11 is provided so that it surrounds the n2+ layer 7. The emitter electrode 12 is provided so that it is in contact with the n1+ layer 6 and the p2+ layer 8. On the back surface of the substrate is provided the collector electrode 13 so that it is in contact with the p1+ layer 3. The p2 layer 11 and the emitter electrode 12 are connected via a nonlinear element S. Here, in the device according to the present invention, the resistance R1 of the conventional device is so large that it can be ignored.

Consequently, as can be seen from the equivalent circuit, it can be considered that the semiconductor device according to the present preferred embodiment has a structure in which the resistance R1 in the equivalent circuit of the conventional device has been replaced by a nonlinear element S.

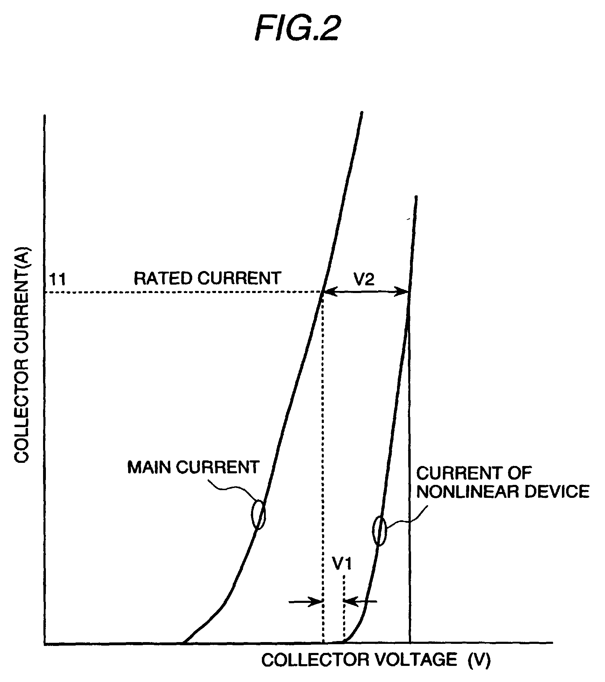

The current-voltage characteristic that this nonlinear element has to satisfy is shown in Fig. 2. The direction of the current through the nonlinear element indicated in Fig. 2 is taken to be positive when it is in the direction of the arrow mark indicated next to the nonlinear element in Fig. 1A. In this figure, the collector voltage at which the main device is in the ON state and is conducting the rated current I1 (A) is indicated by the ON voltage VCEsat (V). This nonlinear element S becomes ON and starts conducting a current when the collector voltage of the main device becomes equal to - the ON voltage VCEsat + V1 (V), and conducts a current equal to I1 when the collector voltage is equal to VCEsat + V2 (V). While the value of VCEsat varies depending on the breakdown voltage of the main device, the value of VCEsat + V1 is roughly 10V or less. It is preferable that 0V<V1*1V or less. In addition, it is preferable that the resistance of the nonlinear element S in the ON state Rs=(V2-V1)/I1 is low, and, in practice, it is appropriate that Rs≤0.01. As long as this nonlinear element satisfies the above conditions, it can be formed on the same chip as the main device or can be provided in the form of a separate chip. Further, in specific terms, this nonlinear element can be prepared using nonlinear elements such as diodes, bipolar transistors, MOSFETs, etc., either individually or in combination, so that the above conditions are satisfied.

In the semiconductor device according to the present preferred embodiment, in the ON state, the nonlinear element S is in the OFF state with the p-base layer at a floating potential, and the current amplification factor of Q2 is still high. Therefore, the electron injection into the n-1 layer 1 from Q2 becomes significant, and hence a low ON voltage is obtained. Further, at the time of turning OFF of the main device, although the voltage of the p2 layer 11 increases with the collector voltage, when the collector voltage increases and the nonlinear element S becomes ON, the p-base layer is connected to the emitter electrode 12 by the nonlinear element that has gone into the low resistance state. As a result, the potential of the p-base layer does not rise, and hence a wide safe operation region will be obtained. Furthermore, in a situation in which the load gets shorted in the ON state, since the nonlinear element becomes ON if the collector voltage increases, the current amplification factor of Q2 decreases, and hence the saturation collector current Isat of the main device gets reduced compared to a conventional device. Because of this, even if a load short-circuit accident occurs, the heat generated in the device will be small and hence a high short-circuit resistance is achieved.

[PREFERRED EMBODIMENT 2]

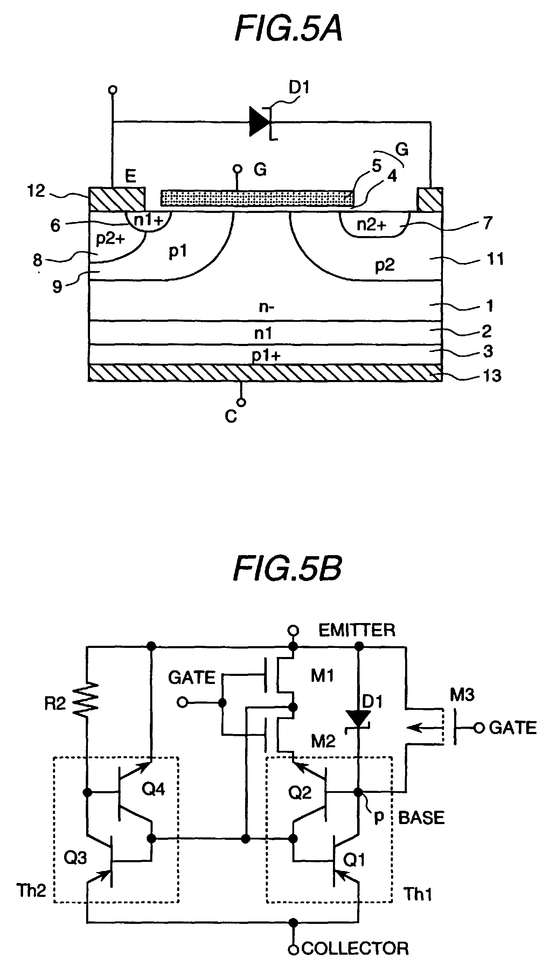

Another preferred embodiment of the present invention is shown in Fig. 5A. The equivalent circuit of the semiconductor device shown in Fig. 5A is shown in Fig. 5B. This preferred embodiment is one in which a Zener diode is used as the nonlinear element S of Fig. 1A. The p2 layer 11 is connected to the emitter electrode (E) 12 via the Zener diode D1. Here, the anode of D1 is connected to the emitter electrode 12. The breakdown voltage of D1 has been set to be larger than the voltage of the p2 layer 11 when the main device is in the rated ON state, so that the conditions expected of the nonlinear element described above are satisfied. In addition, the resistance of D1 after breakdown has been set at a sufficiently low value.

In the present preferred embodiment, when the collector voltage increases and the potential of the p2 layer 11 increases and exceeds VCEsat + V1 (V), the Zener diode D1 breaks down, and the p2 layer 11 gets shorted to the emitter electrode 12 via a low resistance. Because of this, it is possible to expect effects similar to those in the preferred embodiment of Fig. 1A.

In this preferred embodiment, although a Zener diode D1 was used as the nonlinear element S, as long as the conditions are satisfied, it is possible to obtain similar effects if the conditions of the above nonlinear element are satisfied by connecting a single or multiple diodes with the anode of the diode connected to the p2 layer 11.

## [PREFERRED EMBODIMENT 3]

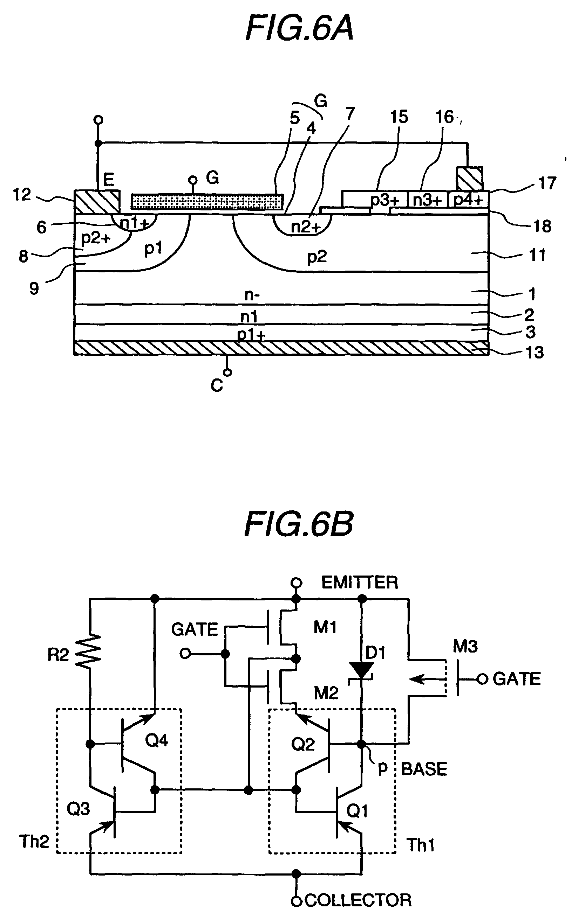

Another preferred embodiment of the present invention is shown in Fig. 6A. This preferred embodiment is one in which several Zener diodes are used as the nonlinear element S of Fig. 1, and are provided on the same substrate as the main semiconductor device. Further, the equivalent circuit of the semiconductor device shown in Fig. 6A is shown in Fig. 6B. The Zener diodes are formed by layers of polycrystalline Si. Here, the p3+ layer 15 is provided by connecting with the p2 layer 11 via a low resistance, the n3+ layer 16 is provided neighboring the p3+ layer 15, and further, the p4+ layer 17 is provided neighboring the n3+ layer 16, and the p4+ layer 17 is connected to the emitter electrode (E) 12 via a low resistance.

As is shown in the equivalent circuit in Fig. 6B, in the present preferred embodiment, the Zener diode D2 formed by the p3+ layer 15 and the n3+ layer 16, and the Zener diode D3 formed by the p4+ layer 17 and the n3+ layer 16 are provided in a back-to-back manner between the p2 layer 11 and the emitter electrode 12.

Here, if the series connected diodes D2 and D3 are made to satisfy the conditions of the above nonlinear element, it is possible to expect effects similar to those in the preferred embodiment of Fig. 1A. In addition, in this preferred embodiment, since the nonlinear element is formed on the same chip as the main device, it is possible to make the reliability higher and also to reduce the number of components.

## [PREFERRED EMBODIMENT 4]

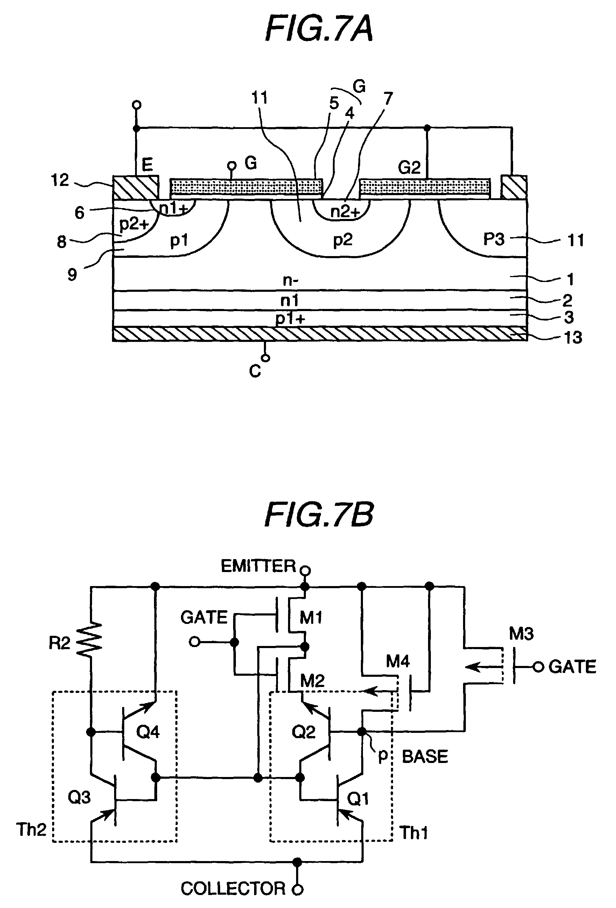

Another preferred embodiment of the present invention is shown in Fig. 7A. This preferred embodiment is one in which a p-channel MOSFET is used as the nonlinear element S of Fig. 1A and is provided on the same substrate as the main semiconductor device. The difference between this preferred embodiment and the preferred embodiment of Fig. 1A is that, instead of the nonlinear element S, the p3 layer 18 is provided in contact with the front surface of the substrate, and a gate G2 is provided in contact with the p2 layer 11 and the p3 layer 18. In addition, the p3 layer 18 and the gate G2 are connected to the emitter electrode 12 via low-value resistances. As is shown in the equivalent circuit of Fig. 7B, this MOSFET is represented as the MOSFET (M3) provided between the p2 layer 11 and the emitter electrode 12.

In this preferred embodiment, the gate G2 is connected to the emitter electrode 12 so that M3 satisfies the above conditions of the nonlinear element. In addition, M3 has been provided so that the potential of the p2 layer 11 becomes equal to the threshold voltage of G2 when the collector voltage becomes equal to VCEsat + V1. Therefore, when the collector voltage exceeds VCEsat + V1 (V), since M3 becomes ON and connects the p2 layer 11 with the emitter electrode 12 via a low resistance, it is possible to expect effects similar to that in the preferred embodiment of Fig. 1A. In addition, in the present preferred embodiment, since the nonlinear element is prepared by a planar process, it is possible to manufacture a device with a high precision and high reliability.

Also, in this preferred embodiment, although an example using a p-channel MOSFET as the nonlinear element was given, it is also possible to provide a similar device using an n-channel MOSFET.

## [PREFERRED EMBODIMENT 5]

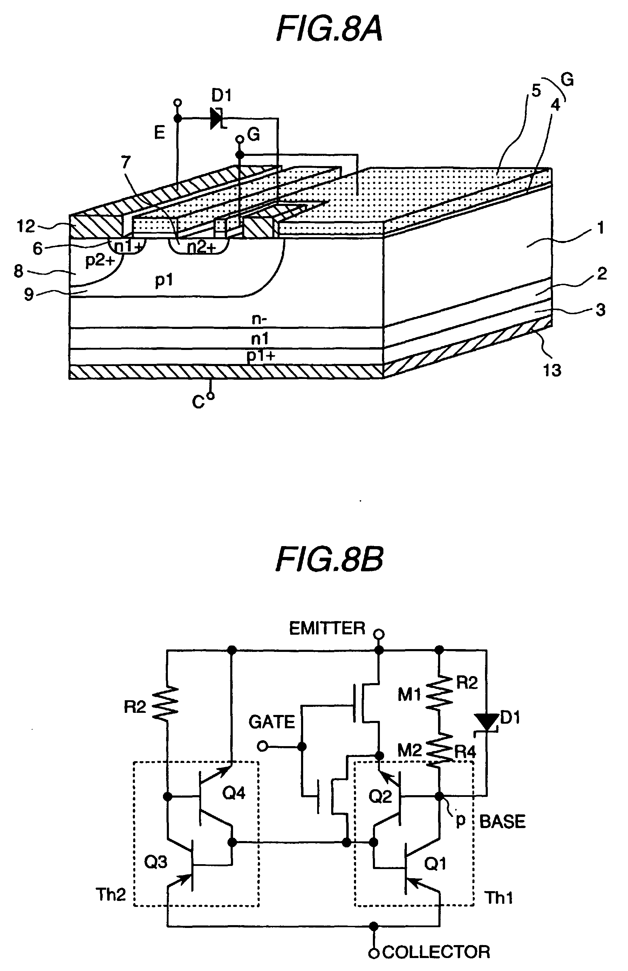

Another preferred embodiment of the present invention is shown in Fig. 8A. This preferred embodiment is an example in which the present invention is applied to other semiconductor devices. In this semiconductor device, the n1 layer 2 and the p1+ layer 3 are formed on the back surface of the n-substrate (n-layer) 1. On the front surface of the substrate is formed an insulated gate G consisting of an insulating film 4 and a gate electrode 5, and an additional insulated gate G3 is formed consisting of an insulating film 4 and a gate electrode 5. An n1+ layer 6 is formed to extend below the insulated gate G and an n2+ layer 7 is formed so that it extends below both the insulated gates G and G3, with both layers being formed on the main front surface. The p2+ layer 8 with a high impurity concentration and in contact with the n1+ layer 6 is formed from the main front surface, and the p1 layer 9 is provided so that it surrounds the n1+ layer 6 and the n2+ layer 7. The emitter electrode 12 is provided so that it is in contact with the n1+ layer 6 and the p2+ layer 8. On the back surface of the substrate is provided the collector electrode 13 so that it is in contact with the p1+ layer 3. A nonlinear element satisfying the conditions given in the preferred embodiment 1 is connected between the emitter electrode 12 and the part on the surface that neighbors the n2+ layer 7 of the p1 layer 9. In this preferred embodiment, a Zener diode D1 is connected as the nonlinear element with its anode on the emitter electrode side. As the nonlinear element, it is sufficient to provide, apart from a Zener diode as in this preferred embodiment, other combinations of diodes, MOSFETs, bipolar transistors, etc., so that the conditions given in the preferred embodiment 1 are satisfied, and it is possible to provide such devices either on the same substrate as the main device to provide them on a separate chip and connect them using interconnections.

As is shown in the equivalent circuit of Fig. 8B, the device according to the present preferred embodiment contains a thyristor (Th1) configured by the pnp transistor (Q1) formed by the p1+ layer 3, the n-layer 1, and the p1 layer 9, and the npn transistor (Q2) formed by the n- layer 1, p1 layer 9, and the n2+ layer 7. This thyristor Th1 is connected to the emitter electrode 12 via the n-channel MISFET (M1) configured by the n1+ layer 6, p1 layer 9, and the n2+ layer 7. At the same time, the transistor Q1 is connected to the emitter electrode 12 via the lateral resistance (R4) below the n2+ layer 7 of the p1 layer 9 and the lateral resistance (R2) below the n1+ layer 6. In addition, a Zener diode D1 is connected in parallel with these resistances R4 and R2. In addition, there is a parasitic thyristor (Th2) comprising the pnp transistor (Q3) configured by the p1+ layer 3, n-layer 1, and p1 layer 9 the npn transistor (Q4) configured by the n- layer 1, p1 layer 9, and n1+ layer 6.

The p1 layer 9, which is the base layer of Q4, is connected to the emitter electrode 12 via the low resistance R2. Because of this, the current amplification factor of Q4 is low, and normally, Th2 does not go ON.

In the semiconductor device according to the present preferred embodiment, a low ON voltage is obtained in the ON state due to the operation of Th1. In addition, since Th1 is connected in series with M1, it is possible to switch ON and OFF the device by the application and removal of voltage to the insulated gate. At the time of turning OFF of the device according to the present preferred embodiment, the holes accumulated in the n- layer flow to the emitter electrode via the p1 layer 9 and the p+2 layer 8.

When the collector current increases and the hole current increases, the potential of the p1 layer 9 rises due to the voltage drop across R4. Normally, when the potential of the p1 layer 9 rises, the turning OFF of the device fails because the junction between the p1 layer 9 and the n2+ layer 7 undergoes voltage breakdown, but in the device according to the present invention, since the Zener diode D1 has been provided, when the potential of the p1 layer 9 rises, the Zener diode D1 breaks down and the p1 layer gets short-circuited to the emitter electrode, there is no possibility of the potential of the p1 layer 11 rising unnecessarily high even if the collector current increases, and hence a wide safe operation region will be maintained.

[PREFERRED EMBODIMENT 6]

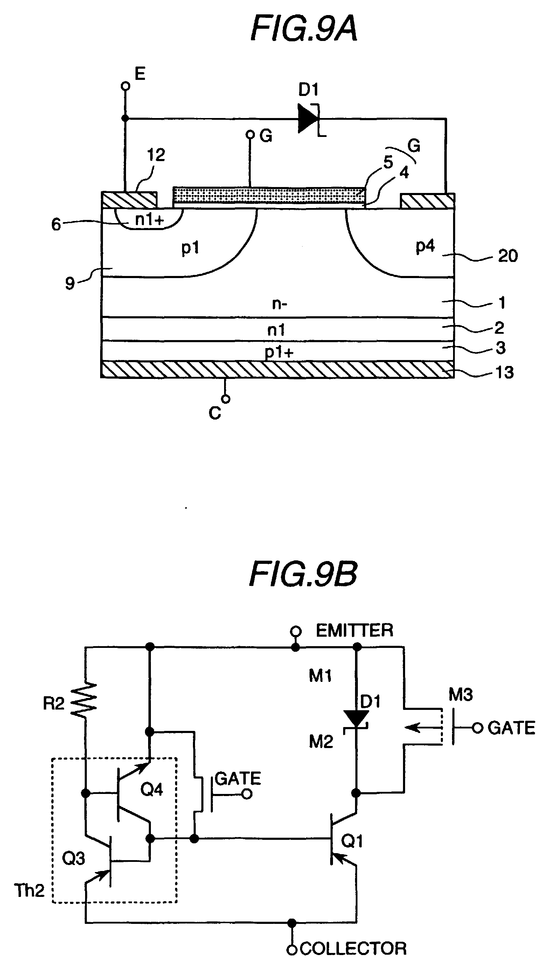

Another preferred embodiment of the present invention is shown in Fig. 9A. This preferred embodiment is an example in which the present invention is applied to other semiconductor devices. In this semiconductor device, the n1 layer 2 and the p1+ layer 3 are formed on the back surface of the n-substrate (n-layer) 1. On the front surface of the substrate is formed an insulated gate G consisting of an insulating film 4 and a gate electrode 5. An n1+ layer 6 is formed so that it extends below the insulated gate G. The p2+ layer 8 with a high impurity concentration and in contact with the n1+ layer 6 is formed from the main front surface, and the p1 layer 9 is provided so that it surrounds the n1+ layer 6. The emitter electrode 12 is provided so that it is in contact with the n1+ layer 6 and the p2+ layer 8. On the back surface of the substrate is provided the collector electrode 13 so that it is in contact with the p1+ layer 3. The p3 layer 20 is formed from the main front surface of the substrate so that it reaches below the insulated gate G, and a nonlinear element satisfying the conditions given in the preferred embodiment 1 is connected between the emitter electrode 12 and the p3 layer 20. In this preferred embodiment, a Zener diode D1 is connected as the nonlinear element with its anode on the emitter electrode side. As the nonlinear element, it is sufficient to provide, apart from a Zener diode as in this preferred embodiment, other combinations of diodes, MOSFETs, bipolar transistors, etc., so that the conditions given in the preferred embodiment 1 are satisfied, and it is also possible to provide such devices either on the same substrate as the main device to provide them on a separate chip and connect them using interconnections.

As is shown in the equivalent circuit of Fig. 9B, the device according to the present preferred embodiment comprises an IGBT configured by a pnp transistor (Q3) configured by the p1+ layer 3, the n-layer 1, and the p1 layer 9, and a MOSFET (M4) configured by the n1+ layer 6, the p1 layer 9, and the n- layer 1, and also a parasitic thyristor (Th2) comprising the npn transistor (Q4) configured by the n- layer 1, the p1 layer 9, and the n1+ layer 6. The p1 layer 9 forming the base layer of Q4 is connected to the emitter electrode 12 via a low-value resistance R2. In addition, the pnp transistor (Q1) configured by the p1+ layer 3, the n- layer 1, and the p3 layer 20 is connected to the collector of Q1 as well as the emitter electrode 12 via the diode D1, and the p-channel MOSFET (M3) configured by the p3 layer 20, the n- layer 1, and the p1 layer 9.

In the semiconductor device according to the present preferred embodiment of the invention, at the time the device is turned OFF, the holes accumulated in the n- layer flow to the emitter electrode via the p1 layer 9 and the p+2 layer 8. Normally, when the collector current rises and the hole current increases consequently, the potential of the p1 layer 9 increases due to the voltage drop across R2 and the parasitic thyristor Th2 operates, thereby causing the turn-OFF operation to fail. But, in the device according to the present invention, since the Zener diode D1 has been provided, when the potential of the p1 layer 9 rises, the p1 layer 9 get short-circuited to the emitter terminal 12 because the diode D1 brakes down. As a consequence, Th2 does hardly become ON even if the collector current increases, and hence a wide safe operation region is maintained.

[PREFERRED EMBODIMENT 7]

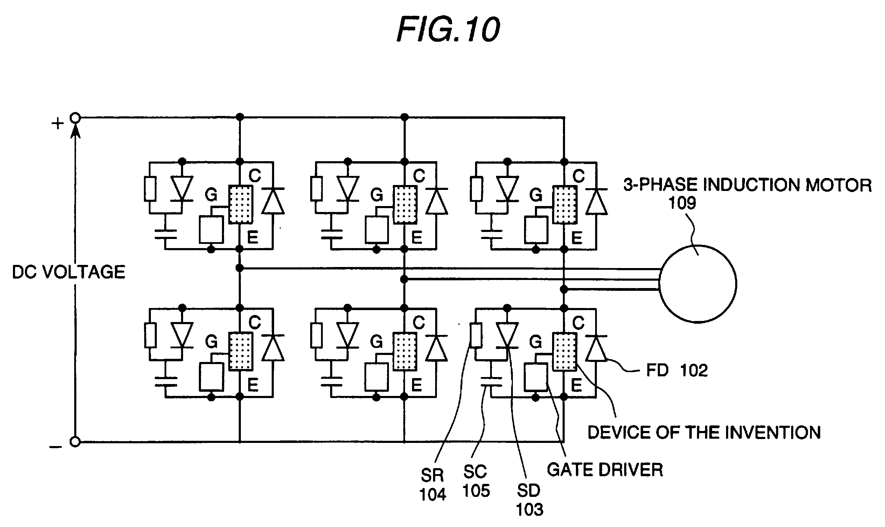

Figure 10 shows an example of the configuration of an inverter apparatus for driving induction electric motors, which is an electrical power conversion apparatus using the semiconductor device according to the present invention. This is an example in which a voltage type inverter circuit is configured using six semiconductor devices according to the present invention thereby controlling a 3-phase induction motor, and the basic circuit of this apparatus comprises semiconductor devices as per the present invention a flywheel diode 102, a snubber diode 104, a snubber resistor 104, and a snubber capacitor 105. In contrast with any conventional apparatus, it has become possible to minimize the snubber circuit and to eliminate it, due to the use of the semiconductor device according to the present invention. In addition, because the devices have a low loss, even the cooling unit for the apparatus can be made smaller in size. Therefore, it was possible to substantially miniaturize the electrical power conversion unit.

By connecting the base layer of the thyristor and the emitter layer 12 using an appropriate nonlinear element, it is possible to realize a small resistive loss (the ON voltage), while at the same time obtaining a complex semiconductor device, and also to realize a power conversion apparatus with a greatly reduced loss and a smaller size.

**Claims**

1. A complex semiconductor device with the feature that, in said complex semiconductor device having a second semiconductor region of second conductivity type exposed on a second main surface on a first semiconductor region of a first conductivity type, a third semiconductor region of the first conductivity type and a fourth semiconductor region of the first conductivity type provided inside said second semiconductor region so as to be exposed on said second main surface, a fifth semiconductor region of the second conductivity type provided inside said third semiconductor region so as to be exposed to said second main surface, a sixth semiconductor region of the second conductivity type provided inside said fourth semiconductor region so as to be exposed on the surface of said second main surface, a first insulated gate formed on said second main surface so as to extend over said fifth semiconductor region and said sixth semiconductor region, a first electrode in low-resistance contact with said first semiconductor region on said first main surface, and a second electrode on said second main surface short-circuiting said third semiconductor region and said fifth semiconductor region, said fourth semiconductor region and said second electrode are connected together by a nonlinear element.

2. A complex semiconductor device according to Claim 1 above with the feature that said nonlinear element goes into the ON state by applying a voltage between said first electrode and said second electrode that is more than the voltage when said complex semiconductor device is conducting its rated current.

3. A complex semiconductor device according to Claim 2 above with the feature that a Zener diode is used as said nonlinear element with its anode being connected to said second electrode.

4. A complex semiconductor device according to Claim 2 above with the feature that a field effect transistor with its gate electrode connected to said second electrode is used as said nonlinear element.

5. A complex semiconductor device with the feature that, in said complex semiconductor device having a second semiconductor region of second conductivity type exposed on a second main surface on a first semiconductor region of a first conductivity type, a third semiconductor region of the first conductivity type provided inside said second semiconductor region so as to be exposed on said second main surface, a fourth semiconductor region and a fifth semiconductor region of the second conductivity type provided inside said third semiconductor region so as to be exposed to said second main surface, a first insulated gate formed on said second main surface so as to extend over said fourth semiconductor region and said fifth semiconductor region, a second insulated gate formed so as to extend over said fifth semiconductor region and said second semiconductor region, a first electrode in low-resistance contact with said first semiconductor region on said first main surface, and a second electrode on said second main surface short-circuiting said third semiconductor region and said fourth semiconductor region, said fourth semiconductor region and said second electrode are connected together by a nonlinear element.

6. A complex semiconductor device with the feature that, in said complex semiconductor device having a second semiconductor region of second conductivity type exposed on a second main surface on a first semiconductor region of a first conductivity type, a third semiconductor region of the first conductivity type provided inside said second semiconductor region so as to be exposed on said second main surface, a fourth semiconductor region of the second conductivity type provided inside said third semiconductor region so as to be exposed to said second main surface, a first insulated gate formed on said second main surface so as to extend over said fourth semiconductor region and said second semiconductor region, a first electrode in low-resistance contact with said first semiconductor region on said first main surface, and a second electrode on said second main surface short-circuiting said third semiconductor region and said fourth semiconductor region, said fourth semiconductor region and said second electrode are connected together by a nonlinear element.

7. An electrical power conversion apparatus with the feature that it employs a complex semiconductor device according to one of the above Claims 1, 2, 3, 4, 5, and 6.

## FIG.1A

## FIG.1B

# FIG.2

# FIG.3A

# FIG.3B

## FIG.4A

## FIG.4B

## FIG.5A

## FIG.5B

## FIG.6A

## FIG.6B

# FIG.7A

# FIG.7B

# FIG.8A

# FIG.8B

## FIG.9A

## FIG.9B

## FIG.10

3-PHASE INDUCTION MOTOR
109

DC VOLTAGE

FD 102

DEVICE OF THE INVENTION

GATE DRIVER

SR    SC    SD
104   105   103

EP 1 075 029 A1

# INTERNATIONAL SEARCH REPORT

| International application No. |
| --- |
| PCT/JP99/01989 |

**A. CLASSIFICATION OF SUBJECT MATTER**
   Int.Cl⁶ H01L29/74

According to International Patent Classification (IPC) or to both national classification and IPC

**B. FIELDS SEARCHED**

Minimum documentation searched (classification system followed by classification symbols)
   Int.Cl⁶ H01L29/74

Documentation searched other than minimum documentation to the extent that such documents are included in the fields searched
   Jitsuyo Shinan Koho              1926-1996
   Kokai Jitsuyo Shinan Koho    1971-1998

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP, 5-190840, A (Semiconductor Research Foundation), 30 July, 1993 (30. 07. 93), Fig. 16 & US, 5323028, A & CN, 1075030, A & DE, 69223390, T2 | 1-7 |
| A | JP, 7-335859, A (Hitachi,Ltd.), 22 December, 1995 (22. 12. 95), Fig. 2 (Family: none) | 1-4, 7 |
| A | JP, 6-334172, A (Fuji Electric Co., Ltd.), 2 December, 1994 (02. 12. 94), Fig. 8 & US, 5378903, A | 5 |

| ☐ Further documents are listed in the continuation of Box C. | ☐ See patent family annex. |
| --- | --- |

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search 13 July, 1999 (13. 07. 99) | Date of mailing of the international search report 21 July, 1999 (21. 07. 99) |
| --- | --- |
| Name and mailing address of the ISA/ Japanese Patent Office | Authorized officer |
| Facsimile No. | Telephone No. |

Form PCT/ISA/210 (second sheet) (July 1992)